# EUROPEAN PATENT APPLICATION

(11) **EP 1 700 680 A1**
(43) Date of publication of application: **13.09.2006**
(21) Application number: 05005105.1
(22) Date of filing: 09.03.2005
(51) Int. Cl.: B29C 33/40, G03F 7/00, B81C 1/00, B29C 59/02

(54) **Easy release fluoropolymer molds for micro- and nano-pattern replication**

(71) Applicant: EPFL Ecole Polytechnique Fédérale de Lausanne, 1015 Lausanne (CH)
(72) Inventor: Barbero David, 1003 Lausanne (CH); Mathieu Hans-Jörg, 1090 La croix sur Lutry (CH); Hoffman Patrick, 1066 Epalinges (CH)
(74) Representative: Cronin, Brian Harold John

(57) **Abstract**

A mold (35) for use in nano- or micro-replication processes on thermoplastic polymer substrates (20), comprises a nano- or micro-structured fluoropolymer surface that, when the mold (35) is used in a nano- or micro-replication process, serves for the application of a nano- or micro-structuration on a thermoplastic polymer substrate (20,22). The nano- or micro-structured fluoropolymer surface is itself obtained by nano- or micro-structuration against the fluoropolymer surface (30) using a master mold (10) of silicon, quartz, nickel, steel, copper, or another material of comparable properties having a nano- or micro-structuration corresponding to that to be applied to a substrate (22). The fluoromold (35) can be used for nano- or micro-imprint lithography, or a liquid polymer can be coated or extruded against the nano-or micro-structured fluoropolymer surface.

## Description

### Field of the Invention

This invention relates to nano- and micro-replication processes including nanoimprint lithography, or other embossing processes, on substrates in particular polymer substrates, and polymer injection processes, using a mold that has a nano- or micro-structured surface which serves for the application by pressure or by polymer injection of a nano- or micro-structuration on a thermoplastic polymer substrate.

In this disclosure, a nanoimprint or nanostructure is one having features in relief measuring from several nanometers (nm) up to several hundreds of nanometers in lateral and vertical dimensions; a miczoinoprint or microstructure is one having features in relief measuring from several microns (µm) up to several hundreds of microns in lateral and vertical dimensions. Generally the lateral feature size is considered for the name (micro- or nano-), and the corresponding structure depths are smaller or up to about 3 times larger. The ratio between depth of structures divided by the lateral structure size is called the aspect ratio and is generally much smaller than unity in most cases. Therefore higher aspect ratios for molding processes are rare and of industrial interest.

### Background of the Invention

Nanoimprint lithography (NIL), or hot-embossing, is a method by which micro and nanostructures are reproduced into a plastic material by heating the polymer above its glass transition temperature (Tg) and applying a force to imprint, or emboss, patterns from a structured mold. After a certain period of time, the polymer is cooled down below Tg, the force is unloaded and the mold is removed from the plastic material. Relatively large areas can be imprinted at once (patterning of 6 inch wafers has been demonstrated previously) and features from several 100s of microns down to less than 10 mn have been reproduced by this technique. Nanoimprint lithography can potentially be used for any application requiring patterning of fine structures on a surface and has been successfully applied to building photodetectors, compact disks, magnetic disks and microfluidic channels.

The mold in NIL is used as the tool that transfers the patterns into the embossed material. The accuracy of the replication therefore depends largely on the definition of the molds' patterns and on the properties of the mold. Molds need to be mechanically, chemically and thermally stable to resist the pressures and temperatures used in this technique. Up to now, molds have been produced mainly in hard, stiff and brittle materials such as silicon, quartz, stainless steel or nickel. However, a number of problems inherent to their physical properties limit their efficiency in the NIL process. Due to their stiffness high pressures are usually applied to obtain conformal contact, and this is a major cause of mold breakage if the pressure is inhomogeneously applied. If the molds were made softer, lower pressures would be necessary to obtain conformal contact. Also, the large difference in thermal expansion between the hard mold and the polymer can be a cause of deformation and fracture of the embossed structures during cooling and de-molding. Finally, an anti-adhesive treatment (perfluorosilanization or fluorinated oil spray) performed onto the mold's surface is necessary to lower its surface energy and decrease adhesion and friction forces during de-molding for easy release. This additional step can be time consuming and has been shown to become ineffective after several imprints leading to polymer adhesion to the mold and increased difficulty in separating the polymer from the mold. Moreover, these perfluorosilane chains tend to hydrolyze at around 130°C and the anti-adhesion treatment may become ineffective during the NIL process since temperatures greater than that are often used.

Using a mold which has a lower stiffness would greatly reduce breakage of the mold due to the possibility to apply lower pressures and because it could be bent during demolding for easy separation of the mold from the imprinted polymer. Soft molds made of poly(dimethylsiloxane) PDMS have been used in microcontact printing to form self-assembled monolayers, in replica molding to replicate patterns of 50 nm or less into polyurethane, and in solvent-assisted microcontact molding (SAMIM) and soft molding on curved and non-flat surfaces, and in hot-embossing to produce large channels for microfluidics. Molds made of PDMS can also be replicated more easily from a single master and with less costly, less time-consuming and more easily accessible technologies than with Si, SiO₂ or nickel stamps.

There are, however, problems associated with the use of PDMS molds. First, PDMS has a low elastic modulus (-2 N/mm²) and structures on the surface of the stamp tend to deform when pressure is applied. Low aspect ratios (<0.3), shallow structures and dense patterns are not stable and tend to collapse resulting in no or deformed replicated patterns. If pressure is applied, like in hot-embossing and nanoimprinting, thick PDMS molds (~5 mm) are necessary to limit pressure non-uniformity and elastomer compression during embossing. Moreover, for high aspect ratio or tall structures relatively large pressures, high temperatures and slow motion are needed to drive the mold into the polymer due to the softness of the PDMS. This also increases time of processing. Finally due to its elastomeric nature, features on the surface of the PDMS mold tend to widen after patterning from a master mold.

For these reasons, composite stamps made of a soft PDMS layer and a hard h-PDMS layer, and also of h-PDMS supported on a flexible glass foil, have been produced and showed less distortion compared to stamps made of PDMS only. However, several problems remain: the first one is associated with the relatively high coefficient of thermal expansion of PDMS (260 µm m⁻¹ °C⁻¹ for 184 PDMS, and 450 µm m⁻¹ °C⁻¹ for h-PDMS) which can force the mold to break off the master during cooling. The second one is due to the fact that h-PDMS tends to crack easily when stress is applied to it. Finally, separation of the h-PDMS stamp from a resist or other polymer was found to be difficult.

In summary, the disadvantages of the molds used up to now are:
- Too high stiffness for silicon, quartz, or metallic stamps which are prone to breakage.
- Too low stiffness for PDMS stamps which leads to deformation of the stamp and the imprinted structure.
- Large difference in thermal coefficient of expansion between the mold and the polymer causing deformation of the structures during cooling due to the higher rate of shrinkage of the polymer compared to the mold.
- The aspect ratio of the patterns is limited to below about 3:1 using current molds.
- Large applied pressures are usually required to obtain conformal contact because of the stiffness of the mold.
- The surface energy of the above-mentioned materials is often too high and requires an additional treatment by perfluorosilanization or with a fluorinated oil spray.
- Breakage of the mold during separation from the polymer being structured.
- The original pattern of the master is reproduced in negative, which can be undesirable.

### Summary of the Invention

According to a main aspect of the invention, there is provided a mold for use in nano-or micro-replication processes on thermoplastic polymer substrates and other substrates, the mold comprising a nano- or micro-structured fluoropolymer surface that, when the mold is used in a nano- or micro-replication process, serves for the application of a nano- or micro-structuration on a substrate.

The nano- or micro- structured fluoropolymer surface is itself obtained by nano- or micro- embossing in the fluoropolymer surface using a mold having a nano- or micro-structuration corresponding to that to be applied to a substrate. The fluoropolymer can be a solid polymer in bulk, sheet or thin-film coating form.

The fluoropolymer forming the mold surface can be any partially or fully fluorinated material which possesses the right properties, as mentioned below under the caption "Materials and Methods". Polytetrafluoroethylene PTFE, Ethylene Tetrafluoroethylene ETFE and Perfluoroalkyl PFA are examples of such materials.

The invention also provides a nano- or micro-replication process which comprises applying a nano- or micro-impression on a substrate using a mold having a nano- or micro- structured fluoropolymer surface as set out above. The nano- or microstructures on the surface of the fluoropolymer are reproduced with high accuracy into the substrate by the application of pressure using methods such as embossing, molding, solvent-assisted molding, injection molding, or without pressure by electrodeposition, sputtering, chemical vapor deposition (CVD), or physical vapor deposition (PVD), or any other method. Each of the preceding techniques, in particular the ones requiring applied pressure, can be performed with or without the application of energy for example as heat, light, UV, laser, x-rays, electron beams, etc.

The substrate can be a thermoplastic polymer, for example Polymethylmethacrylate (PMMA); Polycarbonate (PC); Biaxially Oriented Poly Propylene (BOPP) or any commercially available low cost polymer. Examples are Polyethylene (PE), High-Density Polyethylene HDPE, Polyethylene Terephthalate (PET), Polyamide (PA) like Nylon and Polyacryl (PAA) like Dralon®. Other substrates are possible, including metals.

In this, process, the nano- or micro-structuration can be applied on a thermoplastic polymer substrate by nano- or micro-impression under pressure and at a temperature above the glass transition temperature of the thermoplastic polymer. Alternatively, a liquid polymer can be coated against the nano- or micro-structured fluoropolymer surface.

Also, this process can involve applying a UV curing process to a thermoplastic polymer substrate applied against the nano- or micro-structured fluoropolymer surface, by applying UV radiation through a fluoropolymer surface that is made of a fluoropolymer transparent to UV radiation.

The invention thus applies in general to all nano- and micro-replication processes including embossing and molding such as by nanoimprint lithography, hot embossing, soft molding, injection molding, solvent-assisted microcontact molding, as well as micro contact printing, casting, and UV curing for fluoropolymers transparent to UV. Micro-replication is also possible by other methods that deposit metallic or other substrates on the nano- or micro-structured fluoropolymer surface, for example by electrodeposition, sputtering, chemical vapor deposition (CVD) or physical vapor deposition (PVD).

The invention also concerns a method of producing the above-described fluoropolymer mold by applying onto a fluoropolymer surface that is to form the mold surface a nano- or micro-structure for the application of a corresponding nano-or micro-structuration on a substrate. The nano- or micro-structure can be formed in the fluoropolymer surface by pressure application using a mold of silicon, quartz, nickel, steel, copper, or another material of comparable properties

A final aspect of the invention is the use of a fluoropolymer as nano- or micro-structured surface of a mold for the application of a nano- or micro-structuration on a substrate, including thermoplastic polymer substrates and other substrates.

### Advantages of the Invention

The invention presents a new type of polymeric mold which is flexible, exceptionally resistant to chemicals and which has naturally a very low surface energy to ensure easy release from the substrate. Coating with an anti-adhesive layer is therefore not necessary anymore while using these molds. One main advantage is that we can fabricate with great accuracy a mold made of fluorinated polymer which could not be produced otherwise with the same accuracy by existing techniques. These molds are also stiffer than PDMS, thereby eliminating the problems of deformation associated with PDMS molds. Moreover, thanks to their superior thermal stability, high enough temperatures can be used to ensure low viscosity and good flow of matter for most polymers during nanoimprinting. Since they are made of polymers, these molds have a similar coefficient of thermal expansion than the substrate which eliminates stresses in the substrate and deformation of the patterns during cooling. This is especially important because it enables replication of high aspect ratio structures. Another advantage of these flexible molds is the possibility to use much lower pressures in the embossing, imprinting or molding techniques thanks to the better conformal contact between the mold and a polymer surface. Finally, pattern replication into a polymer can be done by nanoimprinting, injection molding, sputtering, by casting of a liquid polymer like PDMS, or even by LTV curing for certain fluoropolymers transparent to the UV. A perfect positive replication of the original structure (from the master mold) is obtained, which cannot currently be performed with other techniques.

### Brief Description of the Drawings

The invention will now be described in detail by way of examples, and compared with the prior art, with reference to the accompanying drawings, in which:
- Fig. 1a and Fig. 1b schematically illustrate a known nanoimprinting process;
- Figs. 2a to 2d schematically illustrate the fluoromold production according to the invention and subsequent use of the fluoromold to emboss a polymer;
- Fig. 3a is a SEM image of an embossed fluoropolymer (ETFE) mold surface according to the invention and Fig. 3b is the corresponding AFM scan of the ETFE mold;
- Figs. 4a to 4c are SEM images of PMMA sheets embossed using a fluroromold produced by nanoimprint lithography according to the invention, and Fig. 4d is an AMF image of the sample of Fig. 4c; and
- Fig. 5a is an optical image of micropillars produced by the inventive imprint technology in EFTE, and Figs. 5b and 5c are SEM images showing holes embossed in a PMMA sheet using the EFTE mold.

### Detailed Description

### Comparison with the prior art process

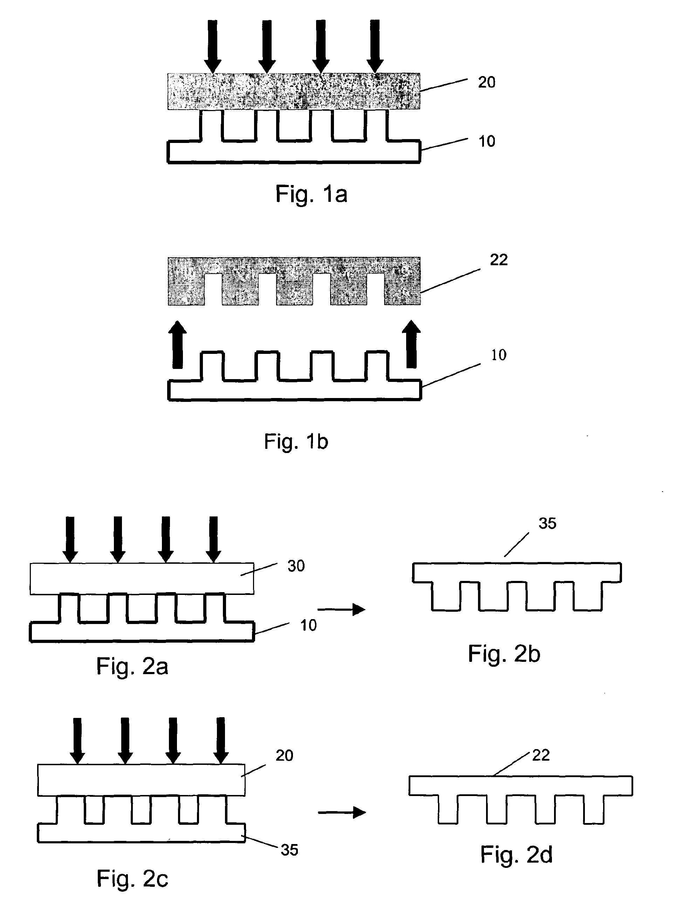

Figs. 1a and 1b schematically illustrate a prior art nanoimprinting process where a substrate 20 of polymer, for example PMMA, is pressed against a master mold 10, typically made of silicon or quartz, with the polymer held at a temperature above its glass transition temperature Tg. The master mold 10 has a nanostructured surface so that this pattern is imprinted into the surface of the polymer 20. After cooling, the polymer 22 now with a nanoimprinted surface, is removed from the master mold 10, as shown in Fig. 1b. In the prior art process, the embossed polymer 22 has a surface which has an inverted structure compared to the master mold 10.

Figs. 2a to 2d schematically illustrate production of the fluoromold 35 according to the invention, which fluoromold 35 is subsequently used to imprint another polymer 20. In Fig. 2a a fluoropolymer substrate 30 is heated above its Tg, the master mold 10 is pressed into the fluoropolymer 30 and removed after a few minutes producing a fluoromold 35 (Fig. 2b) with inverted structures compared to the master mold 10. In Fig. 2c the fluoromold 35 subsequently is used to emboss polymer 20 which as shown in Fig. 2d is structured to produce an embossed polymer 22 with the same patterns as the original master mold 10.

These processes will be further described by way of examples.

### Materials and methods

Fluorinated polymers are unique materials with unmatched properties in terms of thermal, mechanical and chemical stability. Polytetrafluoroethylene (PTFE) for example, due to its stiff chains, ultrahigh molecular weight and extremely high melt viscosity (>10¹¹Pa.s), retains very good mechanical properties at high temperatures and doesn't become liquid when reaching its melting point at 323°C. However, due to these properties, PTFE is also notorious for not being easy to structure by traditional techniques like injection molding or laser ablation. Injection molding is difficult because of the very high melt viscosity of PTFE. Clean ablation cannot be performed with excimer lasers even at 193 nm due to the absence of chromophores in the UV range and due to the high energies (at least 406 kJ/mole) that have to be overcome for bond scission. Structuring by laser ablation therefore requires the use of femtosecond lasers which allow multiphoton absorption processes to initiate sufficient energy accumulation for ablation.

Finally, since PTFE and most fluoropolymers are inert to virtually all solvents except some perfluorokerosenes and perfluorinated oils, they cannot be easily prepared from a solution. Amorphous Teflon AF however can be solution-cast because of its limited solubility in selected perfluorinated solvents.

This invention proposes the structuring of fluorinated polymers using NIL to produce micro and nanostructures. These structured polymers can then be used as molds 35 themselves to pattern other plastics with the added benefit of easy separation of the plastic from the mold, no breakage of the mold, no adhesion of the polymer to the mold, reduced distortion due to thermal effects and high chemical resistance compared to PDMS stamps.

### Examples

Sheets of PTFE and ETFE were processed into molds 35 by nanoimprinting with a master mold 10 made of a stiff material. Two types of master molds 10 were used: a quartz master with nanostructures, and a silicon master with micropatterns.

The polymer sheets 30 and the master mold 10 were disposed onto the lower plate of a press heated to a temperature between 255 and 310°C for PTFE, and between 170 and 240°C for ETFE, a pressure was applied from 30sec to 20 min, and then the material was cooled down between 20 and 100°C before separating the polymer from the mold. The structures obtained are a negative imprint of the master with the same period (2.00-2.05 µm) but with a protruding width of 1.13-1.18 µm according to the dimensions of the master. Higher temperatures were found to give better definition of the imprinted structures, a surface free of voids, and to improve the smoothness of the features in PTFE.

For ETFE, any temperature between 170°C and 240°C gave very well defined features and a smooth surface. This is probably due to the much lower viscosity of ETFE compared to PTFE. Thanks to its lower molecular weight and shorter chains ETFE permits an easier filling of the mold's cavities even at temperatures much below its melting point (250-270°C). For the same reasons, short imprinting times of 30 seconds also gave perfect replication with well-defined patterns and a smooth surface. The AFM scans also show that the height of the structures is 160 nm, identical to the quartz master.

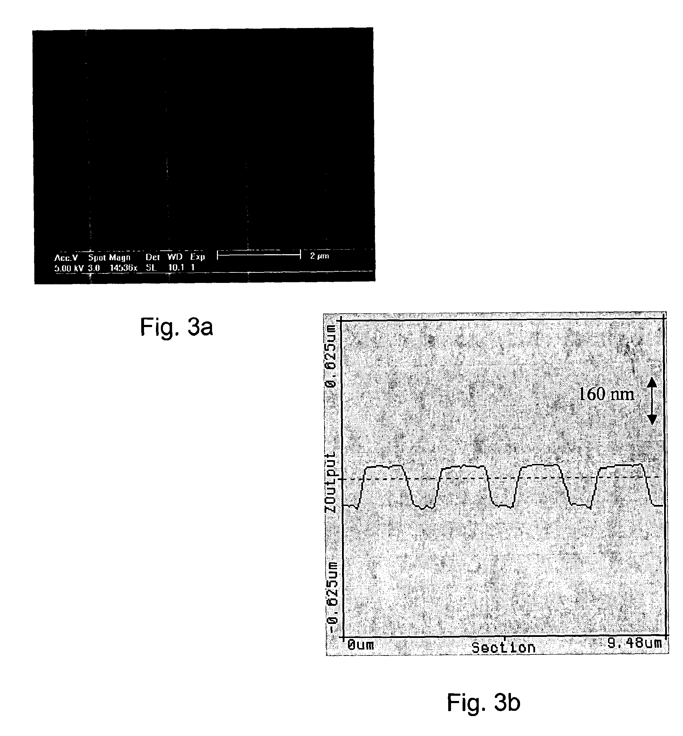

Fig. 3a is a scanning electron microscopy (SEM) image of the embossed ETFE. Fig. 3b is an AFM scan of the ETFE mold 35 showing perfect replication of the original master both laterally (period of 2 microns) and vertically (height of 160 nm).

Polymethylmethacrylate (PMMA) sheets were embossed between 115 and 160°C using the ETFE molds produced by nanoimprint lithography, and up to 195°C with the PTFE mold. This step is schematized in Figs. 2c, and 2d.

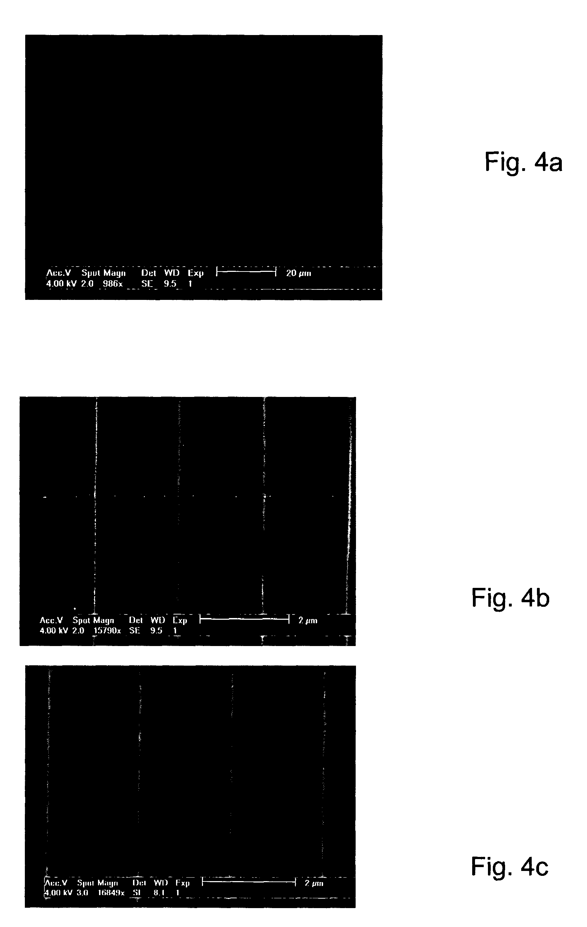

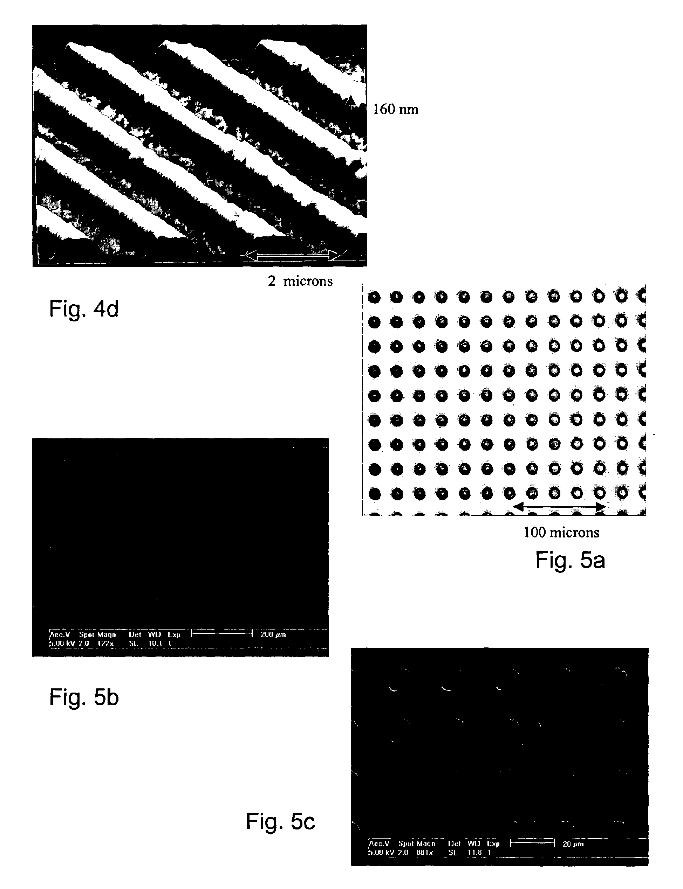

Fig. 4a is a SEM image of a PMMA sheet 22 embossed using a fluoromold 35 produced by nanoimprint lithography according to the invention. Fig. 4b is a SEM close view image of a PMMA sheet embossed using a PTFE mold at a pressure of 4 MPa, and Fig. 4c is a SEM close view image of a PMMA sheet embossed using an ETFE mold at a low pressure of~0.14 MPa. The lateral and vertical dimensions were the same in both cases thereby showing the possibility to reproduce patterns at low pressure. Fig. 4d is an AFM image of the sample shown in Fig. 4c.

Fig. 5a is an optical image of micropillars of 11 microns diameter and 11.5 microns high produced by the inventive imprint technology in an EFTE fluoromold 35. Figs. 5b and 5c are SEM images showing holes embossed in a PMMA sheet 22 using the EFTE mold 35. The holes are also 11 microns diameter and 11.5 microns deep.

These results show that molds made of fluoropolymers give the same embossing quality as traditional stiff quartz or silicon molds for high resolution patterning of nanostructures. Moreover, homogeneity of the embossed patterns was very good, as shown on a larger scale, and the structures had the same definition in the center and at the edge of the substrate.

The invention has thus provided the structuring of fluorinated polymers which cannot be structured in the micro or nanometer range with traditional techniques (injection molding, laser ablation, etc...), The structured surfaces can then be used in two ways: first, the patterned fluoropolymers can be used as such for applications requiring the patterning of various shapes with nanometer or micrometer features; second, they can be used to replicate the structures in another material. When using techniques such as NIL, embossing, soft molding or injection molding or any other embossing or molding method, a perfect replication of the original structure (from the master mold) is obtained, which cannot currently be performed with other techniques. The same perfect replication is obtained when the substrate is applied to the fluoromold by electrodeposition, sputtering, CVD or PVD.

The inventive method has the advantage of producing molds which are inherently non-sticking and allow easy release, without adhesion of the polymer and no deformation nor breakage of the mold or the structures on the substrate. They can be bent to allow sequential release from the structured polymer substrate. The invention also provides excellent replication at much lower pressures than nornnally used. Finally, the much lower mismatch in thermal expansion between the fluoromold and the polymer than with traditional stiff molds or PDMS based molds allows less deformation of the structures during replication and gives the possibility to obtain higher aspect ratios.

## Claims

**1.** A mold for use in nano- or micro-replication processes on substrates, the mold comprising a nano- or micro-structured fluoropolymer surface that, when the mold is used in a nano- or micro-replication process, serves for the application of a nano- or micro-structuration on a substrate.

**2.** The mold of claim 1 wherein the nano- or micro-structured fluoropolymer surface is obtained by nano- or micro-embossing in the fluoropolymer using a master mold having a nano- or micro- structuration corresponding to that to be applied to a substrate.

**3.** The mold of claim 2 wherein the fluoropolymer is a solid polymer in bulk, sheet or thin-film coating form.

**4.** The mold of claim 3 wherein the fluoropolymer is a non soluble fluoropolymer in particular PTFE, ETFE or PFA.

**5.** A nano- or micro-replication process which comprises applying a nano- or micro-structuration on a substrate using a mold having a nano- or micro-impressed fluoropolymer surface as claimed in any preceding claim.

**6.** The process of claim 5 wherein the substrate is applied against the nano- or micro-impressed fluoropolymer surface by the application of pressure, using methods such as embossing, molding, solvent-assisted molding and injection molding, or without the application of pressure, using methods such as electrodeposition, sputtering, chemical vapor deposition (CVD) and physical vapor deposition (PVD).

**7.** The process of claim 5 or 6 wherein the substrate is a thermoplastic polymer in particular Polymethylmethacrylate (PMMA), Polycarbonate (PC), Biaxially Oriented Poly Propylene (BOPP), poly(dimethylsiloxane) (PDMS), or Polystyrene (PS).

**9.** The process of claim 5 or 6 wherein the substrate is a commercially available low cost polymer, in particular selected from Polyethylene (PE), High-Density Polyethylene HDPE, Polyethylene Terephthalate (PET), Polyamide (PA) and Polyacryl (PAA).

**10.** The process of any one of claims 5 to 9 wherein the nano- or micro-structuration is applied on a thermoplastic polymer substrate by nano- or micro-embossing under pressure.

**11.** The process of any one of claims 5 to 9 wherein the nano- or micro-structuration is applied by coating a liquid polymer against the nano- or micro-structured fluoropolymer surface.

**12.** The process of any one of claims 5 to 9 wherein the nano- or micro-structuration is applied by injection molding a polymer against the nano- or micro-structured fluoropolymer surface.

**13.** The process of any one of claims 5 to 12 further comprising performing a UV curing process to a thermoplastic polymer substrate applied against a nano- or micro-structured fluoropolymer surface that is made of a fluoropolymer transparent to UV radiation, by applying UV radiation though the fluoropolymer surface.

**14.** A method of producing the mold of any one of claims 1 to 4, comprising applying onto a fluoropolymer surface that is to form the mold surface a nano- or micro-structure for the application of a corresponding nano-or micro-structuration on a substrate.

**15.** The method of claim 14 wherein the nano- or micro-structure is formed in the fluoropolymer surface by a mold of silicon, quartz, nickel, steel, copper, or another material of comparable properties.

**16.** Use of a fluoropolymer as nano- or micro-structured surface of a mold for the application of a nano- or micro-structuation on a substrate, in particular a thermoplastic polymer substrate.
